# EUROPEAN PATENT APPLICATION

(11) **EP 1 826 904 A2**
(43) Date of publication of application: **29.08.2007**
(21) Application number: 07101324.7
(22) Date of filing: 29.01.2007
(51) Int. Cl.: H03K 17/96

(54) **Touch sensor device**

(30) Priority: 28.02.2006 KR 20060019659
(71) Applicant: Samsung Electronics Co., Ltd., Suwon-si, Gyeonggi-Do (KR)
(72) Inventor: Han, Dong-Kyoon c/o Samsung Electronics Co.Ltd., Gyeonggi-do (KR)
(74) Representative: Grünecker, Kinkeldey, Stockmair & Schwanhäusser Anwaltssozietät

(57) **Abstract**

A touch sensor device includes a light guide plate for guiding light for backlighting; a touch sensor positioned on or underneath the light guide plate and formed with at least one electrode pattern on a surface thereof which faces the light guide plate; and at least one light source positioned on a side surface of the light guide plate for generating light to be directed by the light guide plate. The touch sensor device is thereby significantly thinner and requires much less energy than conventional sensors.

## Description

### BACKGROUND OF THE INVENTION

### 1. Field of the Invention

The present invention relates to a touch sensor, and more particularly, to a touch sensor device with backlight means.

### 2. Description of the Related Art

A backlight used in a conventional capacitance type touch sensor includes a plurality of top emission type light emitting diodes (LEDs). The conventional backlight means is located below the switch of the touch sensor and employs a cylindrical waveguide in order to improve light emitting efficiency to thereby appropriately backlight the corresponding switch.

Since a capacitance type touch sensor device must sense a very fine degree of change in capacitance, it includes a means for blocking surrounding electromagnetic waves. Moreover, in the conventional touch sensor device with backlight means, in order to minimize improper operation due to electromagnetic waves generated by a current change upon the turning on and off of the respective LEDs, the LEDs and the touch sensor are separated from each other by a space that is greater than a predetermined size.

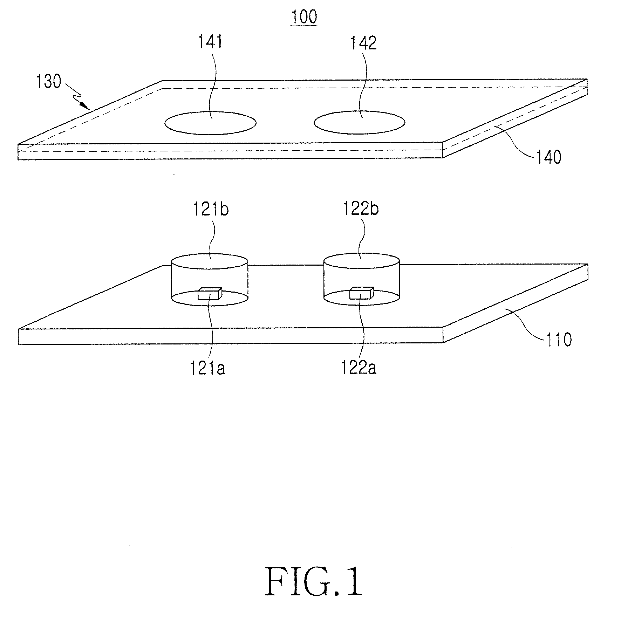

FIG. 1 is a view illustrating the partial construction of a conventional touch sensor device. The conventional touch sensor device 100 includes a touch sensor composed of an electrode layer 140 and a substrate 130 which is positioned on the electrode layer 140 to protect the electrode layer 140 and serve as the substrate of the touch sensor. The substrate is made of a dielectric material such as a polymer or the like. The touch sensor device 100 further comprises a printed circuit board 110 having integrated thereon circuits for controlling and driving the touch sensor.

On the upper surface of the printed circuit board 110, there are positioned a plurality of LEDs 121a and 122a for backlighting the touch sensor and means 121b and 122b for guiding the travel of light generated by the respective LEDs 121a and 122a.

One or more electrode patterns 141 and 142 for producing an electrical contact by a touch from a user are formed on the electrode layer 140. The conventional touch sensor can be used as a capacitance type touch sensor.

However, the conventional touch sensor device has a drawback in that, since a light source and the touch sensor for backlighting must be aligned in a vertical direction for each key and the spacing must be such that the influence of electromagnetic waves is minimized, the thickness of the touch sensor device increases, thereby limiting application of the touch sensor device to portable imaging devices which are being gradually miniaturized.

### SUMMARY OF THE INVENTION

Accordingly, the present invention provides a touch sensor which is thin and miniaturized over the prior art.

According to one aspect of the present invention, there is provided a touch sensor device including a light guide plate for guiding light for backlighting; an electrode layer positioned on or underneath the light guide plate and formed with at least one electrode pattern on a surface thereof which faces the light guide plate; and at least one light source positioned on a side surface of the light guide plate and the electrode layer for generating light to be directed by the light guide plate.

According to another aspect of the present invention, there is provided a touch sensor device including a light guide plate for guiding light for backlighting; a touch sensor positioned at one of on the light guide plate and underneath the light guide plate said touch sensor formed with at least one electrode pattern on a surface thereof which faces one of an upper surface and a lower surface of the light guide plate; and at least one light source positioned on a side surface of the light guide plate for generating light to be directed by the light guide plate.

### BRIEF DESCRIPTION OF THE DRAWINGS

The above and other features and advantages of the present invention will be more apparent from the following detailed description when taken in conjunction with the accompanying drawings, in which:
FIG. 1 is a view illustrating a conventional touch sensor device with backlight means;
FIG. 2 is a view illustrating a touch sensor device with backlight means in accordance with a first embodiment of the present invention; and
FIG 3 is a view illustrating a touch sensor device with backlight means in accordance with a second embodiment of the present invention.

### DETAILED DESCRIPTION OF THE INVENTION

Hereinafter, an embodiment of the present invention is described with reference to the accompanying drawings. In the following description of the present invention, only the parts necessary for understanding of the operations and functions of the present invention are explained, and the explanation for the other parts is omitted so that they do not make the subject matter of the present invention unclear.

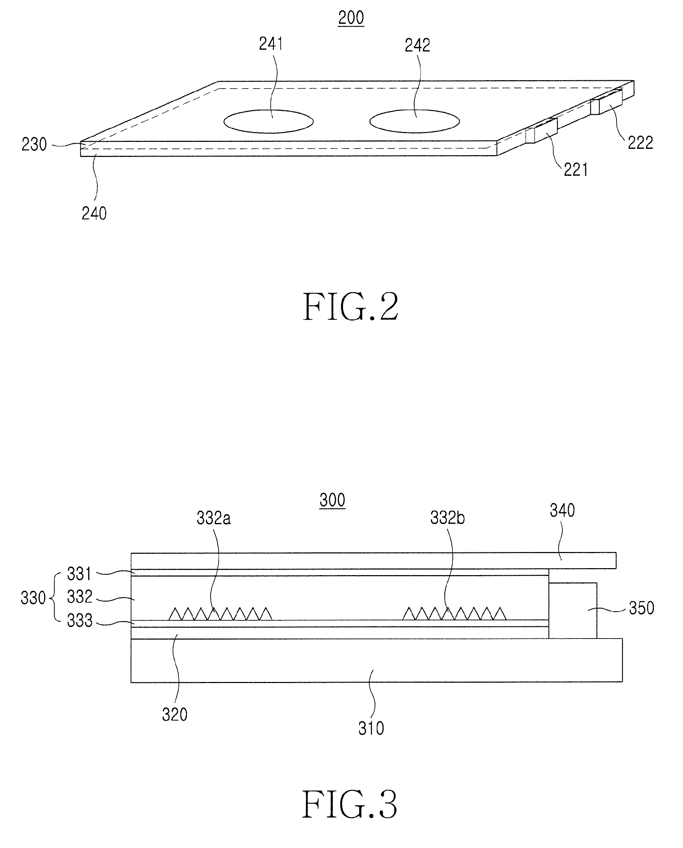

FIG. 2 is a view illustrating a touch sensor device 200 with backlight means in accordance with a first embodiment of the present invention. The touch sensor device 200 according to the first embodiment of the present invention includes a light guide plate 230 for guiding light for backlighting, an electrode layer 240 positioned underneath the light guide plate 230 and formed with one or more electrode patterns 241 and 242 on a surface thereof which faces the light guide plate 230, and at least one light source 221 and 222, positioned on a side surface of the light guide plate 230 and the electrode layer 240, for generating light to be directed by the light guide plate 230. In an alternative embodiment, a printed circuit board (not shown) for driving and controlling the electrode layer 240 is positioned below the electrode layer 240. In an alternative first embodiment, the at least one light source 221 and 222 is preferably a side emission type LED.

An electrode of the electrode layer 240 comprises a conductive polymer or the like, and therefore an electrode and the electrode layer 240 are each made of a transparent material capable of transmitting light. The light guide plate 230 preferably comprises a dielectric material capable of maintaining an electric field produced on the electrode layer 240. In other words, the electrode layer 240 and the light guide plate 230 constitute a touch sensor which senses a current change in the electric field caused by a touch from a conductive object or a human body. Unlike in the construction of the conventional art, since all of the light guide plate 230, in the first preferred embodiment of the present invention, the electrode and the electrode layer 240 are made of a transparent polymeric material such that either of two methods can be employed, which are to separately form the light guide plate 230 and the transparent electrode layer 240 and then bond them together, and to print a transparent electrode for the touch sensor on and thereby completely integrate the transparent electrode for the touch sensor with one surface of the light guide plate 230. Also, due to the fact that the light guide plate 230 and the electrode layer 240 are transparent, in order to provide a backlighting function, the two layers can be constructed to be stacked in an order of the light guide plate 230 and the electrode layer 240, as illustrated in FIG. 2 when viewed from the top, or in a reverse order of the electrode layer 240 and the light guide plate 230, which is not illustrated when viewed from the top, the top side being the side to be touched by a user.

The light guide plate 230 preferably further includes at least one diffusion pattern (not shown) for diffusing the light at a uniform intensity, and guides a light generated by the light sources 221 and 222 and reflects the light being diffused by the diffusion patterns. Also, since the light guide plate 230, according to the first embodiment of the present invention, can function as a substrate that covers the electrode layer 240 of the touch sensor device 200, the present invention provides a touch sensor device having a slim configuration. In an alternative embodiment, the light guide plate 230 is integrated with the light sources 221 and 222 as a flexible printed circuit board (FPCB).

FIG. 3 is a view illustrating a touch sensor device 300 with backlight means in accordance with a second embodiment of the present invention. Referring to FIG. 3, the touch sensor device 300, according to the second embodiment of the present invention, includes a light guide plate 330 for guiding light for backlighting, a touch sensor 320 positioned underneath the light guide plate 330 and formed with at least one electrode pattern on a surface thereof which faces the light guide plate 330, at least one light source 350 positioned on a side surface of the light guide plate 330 for generating light to be directed by the light guide plate 330, a protective layer 340 positioned on the light guide plate 330, and a printed circuit board 310. As described above, since both the light guide plate 330 and the touch sensor 320 are made of a transparent material, their stacking order can be changed in conformity with a design. In an alternative second embodiment, the at least one light source 350 is preferably a side emission type LED.

The touch sensor 320 is attached to the printed circuit board 310 by any medium selected from the group consisting of a bonding pad, adhesives, etc. The touch sensor 320 comprises at least one electrode pattern on an electrode layer for forming an electric field.

The light guide plate 330 includes a core 332 and clads 331 and 333 which respectively cover an upper and lower surface of the core 332 and have a refraction index less than that of the core 332. The clads 331 and 333 preferably comprise a dielectric material or an air layer. Diffusion patterns 332a and 332b for diffusing and reflecting the light generated by the light source 350 are preferably formed on a boundary region between the core 332 and the clad 331 and the clad 333 and are configured adjoining the core 332. The light guide plate 330 preferably is a substrate for maintaining the electric field on the touch sensor 320, comprising a dielectric material.

As is apparent from the above description, the touch sensor device according to the present invention provides advantages in that the touch sensor device is formed to have a thin configuration and backlighting of uniform brightness is provided using a decreased number of LEDs that are used in conventional touch sensors. Therefore, the present invention minimizes power consumption and is configured to have a decreased volume when compared to conventional touch sensors.

Consequently, the present invention can be advantageously applied to miniaturized portable electronic devices.

While the present invention has been shown and described with reference to certain preferred embodiments thereof, it will be understood by those skilled in the art that various changes in form and details may be made therein without departing from the scope of the present invention as defined by the appended claims.

## Claims

1. A touch sensor device comprising:
a light guide plate (230) for guiding light for backlighting;
an electrode layer (240) positioned at one of on and underneath the light guide plate (230) and having at least one electrode pattern (241, 242) on a surface of said electrode layer (240) which faces the light guide plate (230); and
at least one light source (221, 222) positioned on a side surface of the light guide plate (230) and the electrode layer (240), for generating light to be directed by the light guide plate (230).

2. The touch sensor device as set forth in claim 1, wherein the electrode layer (240) comprises a polymer having conductivity.

3. The touch sensor device as set forth in claim 1 or 2, wherein the light guide plate (230) comprises a dielectric material capable of maintaining an electric field produced on the electrode layer (240).

4. The touch sensor device as set forth in claim 3, wherein the electrode layer (240) and the light guide plate (230) constitute a touch sensor.

5. The touch sensor device as set forth in any of claims 1 to 4, wherein the light guide plate (230) is integrated with the light source (221, 222) in the form of a flexible printed circuit board.

6. The touch sensor device as set forth in any of claims 1 to 5, further comprising a printed circuit board positioned below the electrode layer (240).

7. A touch sensor device comprising:
a light guide plate (330) for guiding light for backlighting;
a touch sensor (320) positioned at one of on and underneath the light guide plate (330) and having at least one electrode pattern on a surface of the touch sensor (320) which faces one of an upper surface and a lower surface of the light guide plate (330); and
at least one light source (350) positioned on a side surface of the light guide plate (330) for generating light to be directed by the light guide plate (330).

8. The touch sensor device as set forth in claim 7, wherein the light guide plate (330) comprises core layer (332) and clad layer (331, 333) which respectively cover an upper and lower surface of the core layer (332) and have a refraction index less than that of the core layer (332).

9. The touch sensor device as set forth in claim 7 or claim 8, wherein the light guide plate (330) comprises a dielectric material capable of maintaining an electric field produced on the touch sensor (320).

10. The touch sensor device as set forth in any of claims 7 to 9, further comprising a printed circuit board (310) positioned below the touch sensor (320).

11. The touch sensor device as set forth in any of claims 1 to 10, wherein the light source (221, 222; 350) comprises a side emission type LED.

12. The touch sensor device as set forth in any of claims 1 to 11, wherein the light guide plate (230; 330) comprises a plurality of diffusion patterns for diffusing light at a uniform intensity where the backlighting is required.
